# EUROPEAN PATENT SPECIFICATION

(11) **EP 4 160 224 B1**
(45) Date of publication and mention of the grant of the patent: **01.10.2025**
(21) Application number: 21306373.8
(22) Date of filing: 01.10.2021
(51) Int. Cl.: G01R 15/16, H01R 13/00

(54) **ELECTRIC CONNECTION FOR A SENSOR IN AN ELECTRICAL DISTRIBUTION SYSTEM**
ELEKTRISCHE VERBINDUNG FÜR EINEN SENSOR IN EINEM ELEKTRISCHEN VERTEILUNGSSYSTEM
CONNEXION ÉLECTRIQUE POUR UN CAPTEUR DANS UN SYSTÈME DE DISTRIBUTION ÉLECTRIQUE

(43) Date of publication of application: 05.04.2023
(73) Proprietor: Schneider Electric Industries SAS, 92500 Rueil-Malmaison (FR)
(72) Inventor: BONFILS, Jean-Michel, 38000 Grenoble (FR)
(74) Representative: Plasseraud IP

(56) References cited:
- WO-A1-2017/043699
- US-A- 4 686 518
- US-A- 4 795 982
- US-A1- 2013 299 595

## Description

### Technical Field

The present disclosure relates to sensing in electrical distribution systems, and more particularly to voltage transformers, some embodiments of which are particularly well-suited for metering and/or protection in high-voltage (HV) and/or medium-voltage (MV) environments, such as in MV switchgear, controlgear, and power transformer.

### Background Art

Sensors have been implemented in various components of electrical power transmission and distribution systems. For instance, in MV and HV electrical power distribution systems, resistive or capacitive voltage sensors have been implemented as stand-alone voltage sensors (sometimes referred to as Low Power Voltage Transformers (LPVTs)) for voltage measurement for metering and/or protection (e.g., for protective relays). Such sensors have also been incorporated into some components such as bushings, insulators, and T-connectors, such as those used in HV or MV switchgear, controlgear, and power transformer.

Designing sensors capable of providing required, reliable and accurate voltage measurement (e.g., presence, magnitude and phase) over variations in monitored voltage as well as under high electric fields (e.g., due to neighboring phases) and under additional electrostatic noise, remains technically challenging.

More particularly, the sensor usually needs to be directly electrically coupled to a conductor at a medium or high voltage via a connection area to derive lower voltage measurements that can then be processed as output signals for metering and/or protection. However, as such coupling may be under high dielectric stresses, it may result in arcing, which is a risk for the safety of the electrical distribution system and therefore of people working nearby.

To alleviate these problems, it is known to use electric field deflectors surrounding the connection area between the sensor and the MV/HV conductor, which increases the creepage distance and reduces locally the electrical field so that arcing is no longer likely to occur.

However, adding deflectors requires the sensor to have a geometry that is more complex. Besides, using deflectors increases the need in positioning accuracy of the sensor relative to MV or HV conductor, which may not be easy to obtain. US4795982A and US4686518 show known arrangements comprising a sensor and a high voltage electrical distribution system.

Accordingly, there remains a need for improved sensor that are well-suited for providing accurate voltage measurements, preferably well-suited for use in existing distribution equipment such as switchgear, controlgear, power transformer and/or preferably well-suited for manufacturing cost-effectively.

### Summary of the disclosure

The present invention relates to an arrangement comprising a sensor and a medium voltage or high voltage electrical distribution system comprising a conductive bar as defined in claim 1.

Particular embodiments of the invention are set forth in the dependent claims.

These and other aspects and embodiments are discussed in detail below. The foregoing information and the following detailed description include illustrative examples of various aspects and embodiments, and provide an overview or framework for understanding the nature and character of the claimed aspects and embodiments. The drawings provide illustration and a further understanding of the various aspects and embodiments, and incorporated in and constitute a part of this specification. The drawings, together with the remainder of the specification, serve to describe and explain the claimed aspects and embodiments.

### Brief Description of Drawings

The detailed description is described with reference to the accompanying figures. The same numbers are used throughout the figures to reference like features and components. Some embodiments of the present disclosure are now described, by way of example only, and with reference to the accompanying figures, in which:
**Fig. 1**

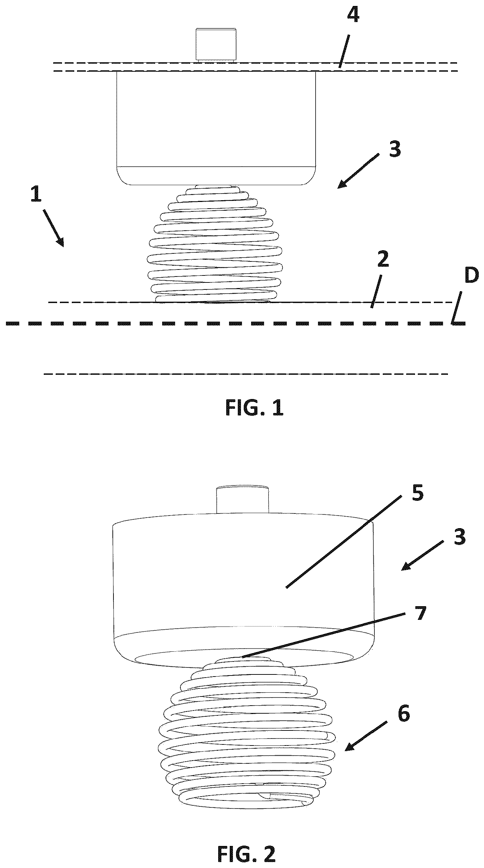

   [Fig. 1] is a partial view of an electrical distribution system, including busbars and a sensor according to an embodiment of the disclosure.
**Fig. 2**
   [Fig. 2] is a front view of the sensor of [Fig. 1].
**Fig. 3**

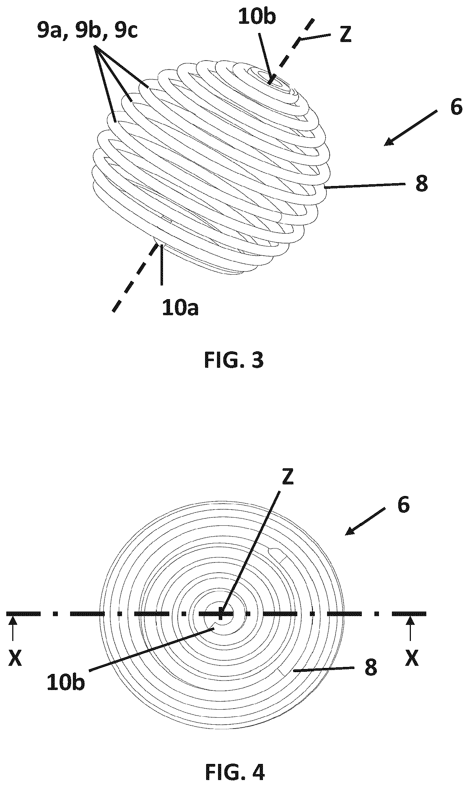

   [Fig. 3] is a perspective view of a conductive contact member of the sensor of [Fig. 2].
**Fig. 4**
   [Fig. 4] is a top view of the conductive contact member of the sensor of [Fig. 2] and [Fig. 3].
Fig. **5**

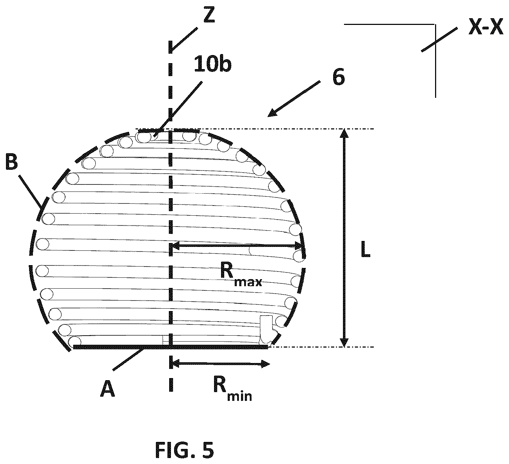

   [Fig. 5] is a sectional view of the conductive contact member of the sensor of [Fig. 3], along plane X-X of [Fig. 4].

### Description of Embodiments

The terms "including", "comprising", "containing", "involving" and variations thereof herein, is meant to encompass the items listed thereafter, equivalents thereof, and additional items, as well as alternate embodiments consisting of the items listed thereafter exclusively.

The phrase "an embodiment" as used herein does not necessarily refer to the same embodiment, though it may. In addition, the meaning of "a," "an," and "the" include plural references; thus, for example, "an embodiment" is not limited to a single embodiment but refers to one or more embodiments. Similarly, the phrase "one embodiment" does not necessarily refer the same embodiment and is not limited to a single embodiment. As used herein, the term "or" is an inclusive "or" operator, and is equivalent to the term "and/or," unless the context clearly dictates otherwise. The term "based on" is not exclusive and allows for being based on additional factors not described, unless the context clearly dictates otherwise.

In addition, as used herein, unless the context clearly dictates otherwise, the term "coupled" refers to directly connected or to indirectly connected through one or more intermediate components and, in some contexts, may also denote or include electrically coupled, such as conductively coupled, capacitively coupled, and/or inductively coupled. Further, "conductively coupled (connected)," and "electrically coupled (connected)," and similar variants, each refer to being coupled (connected) via one or more intermediate components that permit energy transfer via conduction current.

In addition, it will be understood that terminology such as "top," "upper," "bottom," "lower," "side," and the like, as used herein is a convention simply for convenience and ease of reference with respect to referring to the various views presented in the drawings, and does not otherwise impart any limitation on the overall design and/or orientation of the sensor in accordance with the present disclosure.

Further, for ease of reference, as used herein, the term "conductive" or "conductor" refers to electrically conductive or an electrical conductor (rather than, for example, thermal conductivity), unless the context clearly dictates otherwise. In this regard, it will be further understood that the term "conductive," as used herein, refers to the electrical conductivity of a material or component (e.g., in contrast to an insulator or dielectric) and not to whether the material or component is actively conducting current or even configured to conduct current, though some conductors may be configured for conducting current.

For clarity, while the terms medium-voltage and high-voltage may have different definitions in various standards, or otherwise may be understood as having different meanings in various contexts, as used herein, medium-voltage may refer to an alternating current (AC) root-mean-square (rms) voltage in the range of about 1 KV to about 52 KV or to a direct current (DC) voltage in the range of about 1.5 KV to about 75 KV; and high-voltage may refer to an alternating current (AC) rms voltage greater than about 52 KV or to a direct current (DC) voltage greater than about 75 KV. As may be understood by the ensuing disclosure, however, embodiments in accordance with the present disclosure are not limited to a particular voltage or voltage range.

Referring to [Fig. 1], a partial view of an electrical distribution system 1 is shown with a MV or HV conductive bar 2 extending in a longitudinal direction D. The conductive bar 2, also referred to below as busbar, can be housed inside a switchgear, panel boards, and busway enclosures, to connect MV or HV equipment at electrical switchyards.

Busbars 2 are generally uninsulated conductive bars and have sufficient stiffness to be supported in air or insulating gas by insulated pillars. Busbars 2 can be produced in a variety of shapes, such as flat strips, solid bars, or cylindrical rods, and are typically composed of copper, brass, or aluminum as solid or hollow tubes.

With reference to [Fig. 1], a sensor 3 can be used to perform voltage measurement on one phase of the electrical distribution system by being conductively coupled to one busbar 2. The sensor 3 may also be used for metering, in particular phase shift metering, and/or for powering various auxiliary products of the electrical distribution system with low voltage derived from the current flowing into the busbar 2. To this regard, the sensor 3 is disposed advantageously perpendicularly to the longitudinal direction D of the busbar 2, and can be fixed to a metal sheet 4, or any other supporting element, that is located nearby the busbar 2. Several sensors may be used to monitor each phase of the electrical distribution system, i.e. by having one sensor per phase.

As illustrated more particularly in [Fig. 2], the sensor 3 includes a body 5 and a conductive contact member 6.

The body 5 is made of an insulating material, such as an epoxy resin, and can have any shape and size, for instance cylindrical, cubical or others, with or without sheds. As illustrated in [Fig. 2], the body has a cylindrical shape.

The conductive contact member 6 is electrically connected to the body 5 via an attachment point 7 using a threaded bolt and washer for instance. However, other attachment means are also possible between the conductive contact member 6 and the body 5, including soldering, riveting, etc.

Electronic components may be embedded in the body 5 and electrically coupled with the conductive contact member 6 via the attachment point 7, for instance to form a capacitive, resistive and/or inductive voltage divider and to provide an output signal of the sensor 3. The electronic components may be disposed on or in a printed circuit board (not illustrated) that is mounted and overmolded in the body 5.

[Fig. 3] is a perspective view of the conductive contact member 6 embodying the present disclosure.

The conductive contact member 6 comprises a coil spring 8 with multiple turns 9a, 9b, 9c, etc. The coil spring 8 is made by winding a wire made of a conductive material, such as stainless steel. The wire can have a diameter of around 2.5 millimeters.

With reference to [Fig. 3], the coil spring 8 extends between a lower end 10a, to be electrically coupled to the busbar 2, and an upper end 10b to be attached to the body 5. The lower end 10a and the upper end 10b face away from each other, the conductive contact member extending in a vertical direction Z as illustrated in [Fig. 3], [Fig. 4] and [Fig. 5].

The coil spring 8 (when undeformed) has a length L in the vertical direction Z, as referenced in [Fig. 5], comprised between 20 and 50 millimeters, preferably equal to 35 millimeters. The coil spring 8 is elastically deformable in the vertical direction Z, so that the length L decreases when the coil spring 8 is compressed.

The lower end 10a, also visible on [Fig. 5], corresponds to one end of the wire and may also correspond to a last turn of the wire delimiting an external end surface. As illustrated also in [Fig. 5], the lower end 10a is curved internally within the external end surface to avoid any dielectric stress at its tip.

The external end surface forms an opening between the inside and the outside of the conductive contact member 6, that is preferably circular. The term "external end surface" is therefore meant to designate a virtual surface that intersects the last turn of the coil spring 8 in the vicinity of the lower end 10a, as shown as a solid line A in [Fig. 5]. The external end surface is advantageously transversal to the vertical direction Z, the vertical direction Z passing through a barycenter of the external end surface. The external end surface corresponds to the connection area of the sensor 5 that is to be electrically coupled to the busbar 2, as detailed below.

The upper end 10b, also visible on [Fig. 4] and [Fig. 5], corresponds to the other end of the wire, that is to be fixed to the body 5 at the attachment point 7. In particular, the upper end 10b can be rolled up on itself at the attachment point 7. Starting from the attachment point 7 or the upper and 10b, the coil spring 8 is helical, i.e. the wire turns around the vertical direction Z at a prescribed pitch while moving in the vertical direction Z.

The coil spring 8 also delimits an external lateral surface. The term "external lateral surface" is meant to designate a virtual surface that intersects all the turns 9a, 9b, 9c, etc. of the coil spring 8, as shown as a dotted line B in the cross-section of [Fig. 5]. Advantageously, the external lateral surface of the coil spring 8 is rotationally symmetrical around the vertical direction Z.

The coil spring 8 preferably has a rounded shape that extends from the attachment point 7. To this end, the coil spring 8 can be formed by winding the wire into a rounded shaped former.

The term "rounded shape" is meant to encompass any curved external lateral surface of the coil spring 8. Also, the external lateral surface of the coil spring does not comprise any sharp edge or corner. In cross-section, the external lateral surface of the coil spring 8 may be a portion of a spheroid or ellipsoid of revolution.

More precisely, the external lateral surface may have the shape of a spherical cap or spherical dome, i.e. a portion of a sphere (a sphere cut off by the plane comprising the external end surface).

The coil spring 8 has a maximum radius Rₘₐₓ located between the lower and upper ends 10a, 10b and a radius Rₘᵢₙ at the external end surface. The maximum radius Rₘₐₓ is for instance equal to around 25 millimeters and the radius Rₘᵢₙ is for instance equal to around 20 millimeters.

An electric connection can be established with the busbar 2 by positioning the sensor 3 in a direction perpendicular to the longitudinal direction D so that the conductive contact member 6 comes into contact with a part of the uninsulated contact surface of the busbar 2, and the coil spring 8 is resiliently compressed in the vertical direction Z. The coil spring 8, and more precisely at least all or part of the last turn of the coil spring 8, can be thus in contact with the busbar 2 with a certain resilient force so that a sufficient electric contact can be ensured between the sensor 3 and the busbar 2. The vertical direction Z of the conductive contact member 6 is then perpendicular to the longitudinal direction D.

When the connection area is brought into contact with the busbar 2 (which can have a flat or curved contact surface), linear or surface electrical connection may be anywhere along the last turn of the coil, and thus belongs to the external end surface. In other words, the positioning of the sensor 3 may vary along the longitudinal direction D as long as the last turn of the coil spring 8 remains in electrical connection with the busbar 2.

Besides, due to the resilient compression between the coil spring 8 and the busbar 2, the positioning of the sensor 3 may slightly vary perpendicularly to the direction D while still being conductively coupled with the busbar 2. Pitch between turns and material of the wire can be chosen accordingly.

Because of the medium or high voltage surrounding the sensor 3, an electric field exists on its external surface. The rounded shape of the coil spring 8 reduces dielectric constraints of the sensor 3. It acts as a Faraday cage or shield formed by the turns of the coil spring 8 and blocking, or at least limiting, electric field inside of the conductive contact member 6.

Although the electric field is also usually important at an attachment point, which constitutes a triple junction or interface between respectively the insulated material of the body, the conductive contact member and the gaseous medium surrounding the sensor 3 (e.g. air), properties and shape of the conductive contact member 6 allows the electric field to be further reduced.

According to the invention, the inside of the conductive contact member 6, delimited by the external lateral surface and the external end surface, houses one or several additional devices. Such devices can be a thermal sensor, a vibration sensor and more generally any electronic equipment more particularly sensitive to electrostatic field and that may be used to monitor, meter and/or protect the electrical distribution system.

By being located inside the conductive contact member 6, these additional devices benefit from the conductive contact member 6 to be protected against any dielectric stress.

Although the present invention has been described above with reference to specific embodiments, it is not intended to be limited to the specific form set forth herein. Rather, the invention is limited only by the accompanying claims and, other embodiments than the specific above are equally possible within the scope of these appended claims.

Furthermore, although exemplary embodiments have been described above in some exemplary combination of components and/or functions, it should be appreciated that, alternative embodiments may be provided by different combinations of members and/or functions without departing from the scope of the present disclosure as defined in the appended claims. In addition, it is specifically contemplated that a particular feature described, either individually or as part of an embodiment, can be combined with other individually described features, or parts of other embodiments.

## Claims

1. An arrangement comprising a sensor (3) and a medium voltage or high voltage electrical distribution system (1) comprising a conductive bar (2) which extends along a longitudinal direction (D),
in which the sensor (3) is fixed to a supporting element (4) of the electrical distribution system (1) to be positioned perpendicularly to the longitudinal direction (D) and is in electrical contact with the conductive bar (2),
in which the sensor is configured to be electrically coupled to the conductive bar (2) of the medium voltage or high voltage electrical distribution system (1), the sensor comprising:
- a body (5), and
- a conductive contact member (6), the body and the conductive contact member (6) being attached together at an attachment point (7), wherein the conductive contact member (6) is a coil spring (8) formed by winding a wire into a rounded shape that extends from the attachment point (7),
**characterized in that** an electronic device is housed in the internal volume of the conductive contact member (6), the internal volume being delimited by an external lateral surface (B) and an external end surface (A) of the coil spring (8).

2. The arrangement according to claim 1, wherein the coil spring (8) has the shape of a spherical cap or spherical dome.

3. The arrangement according to any of the preceding claims, wherein the coil spring (8) extends in a vertical direction (Z) between a lower end (10a) to be electrically coupled to the conductive bar (2) at a connection area and an upper end (10b) attached to the body (5) at the attachment point (7).

4. The arrangement according to claim 3, wherein the lower end (10a) corresponds to a last turn of the wire of the coil spring (8) and delimits an external end surface (A) to be into contact with the conductive bar (2).

5. The arrangement according to claim 3 or 4, wherein the coil spring (8) delimits an external lateral surface that is rotationally symmetrical around the vertical direction (Z).

6. The arrangement according to any of claims 3 to 5, wherein the coil spring (8) has a maximum radius (Rₘₐₓ) located between the lower and upper ends (10a, 10b) and a minimum radius (Rₘᵢₙ) at the location of the external end surface.

7. The arrangement according to any of claims 3 to 6, wherein the coil spring (8) is helical, the wire turning around the vertical direction (Z) starting from the attachment point (7), while moving in vertical direction (Z).

8. The arrangement according to any of the preceding claims, configured to be a low-power voltage transformer (LPVT) sensor.

9. The arrangement according to any of the preceding claims, wherein the body (5) comprises electronic components that are configured to process the voltage of the conductive bar (2) into a low-voltage output signal of the sensor (3).

## Patentansprüche

1. Anordnung, die aufweist: einen Sensor (3) und ein elektrisches Verteilungssystem (1) mit mittlerer Spannung oder hoher Spannung, das einen leitenden Stab (2) aufweist, der sich entlang einer Längsrichtung (D) erstreckt,
wobei der Sensor (3) an einem Halteelement (4) des elektrischen Verteilungssystems (1) befestigt ist, so dass er senkrecht zu der Längsrichtung (D) positioniert ist und in elektrischem Kontakt mit dem leitenden Stab (2) ist,
wobei der Sensor derart konfiguriert ist, dass er mit dem leitenden Stab (2) des elektrischen Verteilungssystems (1) mit mittlerer Spannung oder hoher Spannung elektrisch gekoppelt ist, wobei der Sensor aufweist:
- einen Körper (5), und
- ein leitendes Kontaktelement (6), wobei der Körper und das leitende Kontaktelement (6) an einem Befestigungspunkt (7) aneinander befestigt sind, wobei das leitende Kontaktelement (6) eine Spiralfeder (8) ist, die ausgebildet wird, indem ein Draht in eine abgerundete Form gewickelt wird, welche sich von dem Befestigungspunkt (7) erstreckt,
**dadurch gekennzeichnet, dass** eine elektronische Vorrichtung in einem Innenvolumen des leitenden Kontaktelements (6) untergebracht ist, wobei das Innenvolumen durch eine äußere seitliche Oberfläche (B) und eine äußere Endoberfläche (A) der Spiralfeder (8) begrenzt wird.

2. Anordnung nach Anspruch 1, wobei die Spiralfeder (8) die Form einer kugelförmigen Kappe oder einer kugelförmigen Kuppel hat.

3. Anordnung nach einem der vorhergehenden Ansprüche, wobei die Spiralfeder (8) sich in einer Vertikalrichtung (Z) zwischen einem unteren Ende (10a), das an einem Verbindungsbereich mit dem leitenden Stab (2) elektrisch gekoppelt werden soll, und einem oberen Ende (10b) erstreckt, welches an dem Befestigungspunkt (7) an dem Körper (5) befestigt ist.

4. Anordnung nach Anspruch 3, wobei das untere Ende (10a) einer letzten Wicklung des Drahts der Spiralfeder (8) entspricht und eine äußere Endoberfläche (A), die in Kontakt mit dem leitenden Stab (2) sein soll, beschränkt.

5. Anordnung nach Anspruch 3 oder 4, wobei die Spiralfeder (8) eine äußere seitliche Oberfläche begrenzt, welche um die Vertikalrichtung (Z) herum rotationssymmetrisch ist.

6. Anordnung nach einem der Ansprüche 3 bis 5, wobei die Spiralfeder (8) einen maximalen Radius (Rₘₐₓ), der zwischen den unteren und oberen Enden (10a, 10b) angeordnet ist, und einen minimalen Radius (Rₘᵢₙ) an der Stelle der äußeren Endoberfläche hat.

7. Anordnung nach einem der Ansprüche 3 bis 6, wobei die Spiralfeder (8) schraubenförmig ist, wobei der Draht sich beginnend von dem Befestigungspunkt (7) um die Vertikalrichtung (Z) wickelt, während er sich in der Vertikalrichtung (Z) bewegt.

8. Anordnung nach einem der vorhergehenden Ansprüche, die konfiguriert ist, um ein Sensor eines Niederleistungs-Spannungstransformators (LPVT) zu sein.

9. Anordnung nach einem der vorhergehenden Ansprüche, wobei der Körper (5) elektronische Komponenten aufweist, die konfiguriert sind, um die Spannung des leitenden Stabs (2) in ein Niederspannungs-Ausgangssignal des Sensors (3) zu verarbeiten.

## Revendications

1. Agencement comprenant un capteur (3) et un système de distribution électrique moyenne tension ou haute tension (1) comprenant une barre conductrice (2) qui s'étend selon une direction longitudinale (D),
dans lequel le capteur (3) est fixé à un élément de support (4) du système de distribution électrique (1) à positionner perpendiculairement à la direction longitudinale (D) et est en contact électrique avec la barre conductrice (2),
dans lequel le capteur est configuré pour être couplé électriquement à la barre conductrice (2) du système de distribution électrique moyenne tension ou haute tension (1), le capteur comprenant :
- un corps (5), et
- un organe de contact conducteur (6), le corps et l'organe de contact conducteur (6) étant fixés ensemble au niveau d'un point de fixation (7), dans lequel l'organe de contact conducteur (6) est un ressort bobiné (8) formé par enroulement d'un fil en une forme arrondie qui s'étend à partir du point de fixation (7),
**caractérisé en ce qu'**un dispositif électronique est logé dans le volume interne de l'organe de contact conducteur (6), le volume interne étant délimité par une surface latérale externe (B) et une surface d'extrémité externe (A) du ressort bobiné (8).

2. Agencement selon la revendication 1, dans lequel le ressort bobiné (8) a la forme d'un capuchon sphérique ou d'un dôme sphérique.

3. Agencement selon l'une quelconque des revendications précédentes, dans lequel le ressort bobiné (8) s'étend dans une direction verticale (Z) entre une extrémité inférieure (10a) à coupler électriquement à la barre conductrice (2) au niveau d'une zone de connexion et une extrémité supérieure (10b) fixée au corps (5) au niveau du point de fixation (7).

4. Agencement selon la revendication 3, dans lequel l'extrémité inférieure (10a) correspond à un dernier tour du fil du ressort bobiné (8) et délimite une surface d'extrémité externe (A) à mettre en contact avec la barre conductrice (2).

5. Agencement selon la revendication 3 ou 4, dans lequel le ressort bobiné (8) délimite une surface latérale externe qui est symétrique en rotation autour de la direction verticale (Z).

6. Agencement selon l'une quelconque des revendications 3 à 5, dans lequel le ressort bobiné (8) présente un rayon maximal (Rₘₐₓ) situé entre les extrémités inférieure et supérieure (10a, 10b) et un rayon minimal (Rₘᵢₙ) au niveau de l'emplacement de la surface d'extrémité externe.

7. Agencement selon l'une quelconque des revendications 3 à 6, dans lequel le ressort bobiné (8) est hélicoïdal, le fil tournant autour de la direction verticale (Z) en partant du point de fixation (7), tout en se déplaçant dans la direction verticale (Z).

8. Agencement selon l'une quelconque des revendications précédentes, configuré pour être un capteur de transformateur de tension basse puissance (LPVT).

9. Agencement selon l'une quelconque des revendications précédentes, dans lequel le corps (5) comprend des composants électroniques qui sont configurés pour traiter la tension de la barre conductrice (2) en un signal de sortie basse tension du capteur (3).
